# EUROPÄISCHE PATENTSCHRIFT

(11) **EP 1 898 686 B1**
(45) Veröffentlichungstag und Bekanntmachung des Hinweises auf die Patenterteilung: **24.06.2009**
(21) Anmeldenummer: 06018862.0
(22) Anmeldetag: 08.09.2006
(51) Int. Cl.: H05K 9/00

(54) **Kurzschlussfestigkeitsoptimiertes Halbleiterschaltmodul**
Semiconductor module with improved short circuit resistance
Module semi-conducteur avec résistance optimisée contre les court-circuits

(43) Veröffentlichungstag der Anmeldung: 12.03.2008
(73) Patentinhaber: SIEMENS AKTIENGESELLSCHAFT, 80333 München (DE)
(72) Erfinder: Jonas, Stephan, 92431 Neunburg (DE); Meier, Markus, 92286 Rieden (DE); Viala, Bertrand, 92224 Amberg (DE)

(56) Entgegenhaltungen:
- EP-A2- 1 420 624
- DE-A1- 3 404 201
- GB-A- 2 396 059

## Beschreibung

Die Erfindung betrifft ein Halbleiterschaltmodul mit einem Gehäuse, wobei das Gehäuse zur Abfuhr eines in einem Kurzschlussfall entstehenden Druckes Öffnungen aufweist. Die Erfindung betrifft ferner ein derartiges Gehäuse für ein Halbleiterschaltmodul. Ein Gehäuse mit Öffnungen ist aus dem Dokument EP-A-1420624 bekannt.

Schaltgeräte für Verbraucherabzweige wie die genannten Halbleiterschaltmodule werden z.B. in Schaltanlagen eingesetzt. Diese Schaltanlagen werden im Regelfall in mehreren Ebenen gegen Kurzschlüsse abgesichert (Einspeisung, Verteilung, Verbraucher). Die Stromgröße des maximal möglichen Kurzschlusses in der jeweiligen Ebene hängt von den Komponenten der Anlage ab. Aus Kundensicht ist es erstrebenswert, Schaltgeräte einzusetzen, deren maximal zulässiger Kurzschlussstrom möglichst hoch ist. Dies erleichtert die Projektierung und vermeidet kostenrelevante Zusatzmaßnahmen zur Begrenzung der Kurzschlusshöhe.

Das Verhalten des Schaltgerätes bei maximalem Kurzschlussstrom in Verbindung mit einem bestimmten Kurzschlussschutzorgan (Leistungsschalter oder Sicherung) wird in der IEC bzgl. zweier Zuordnungsarten unterschieden: Bei der Zuordnungsart 1 darf das Schaltgerät nach dem Kurzschluss defekt sein, Anlagenteile oder Personen dürfen jedoch nicht gefährdet werden (d.h. z.B. stromführende Teile dürfen nicht berührbar sein). Bei der Zuordnungsart 2 muss das Schaltgerät nach dem Kurzschluss noch funktionsfähig sein, Reparaturen am Schaltgerät sind jedoch zulässig. Bei Schaltgeräten ist eine Erfüllung der Zuordnungsart 1 die Mindestanforderung.

Die bei den Kurzschlüssen auftretenden Beanspruchungen sind kurzzeitige, schlagartige Druckwellen, die durch das Verdampfen von stromführenden Teilen, vor allem Bonddrähten, entstehen. Bei einem steifen und dichten Gehäuse führen diese zum Bersten des Gehäuses. Lösungsansätze sind, die Gehäuse extrem steif und fest zu gestalten - um dem Druck stand zu halten - oder das Gehäuse mit ausreichend großen Öffnungen zu versehen - um den Druckabbau zu ermöglichen. Erstere Lösung führt zu sehr teuren und großvolumigen Aufbauten. Letztere Lösung führt zu kostenoptimierten Aufbauten, kollidiert jedoch häufig mit weiteren Anforderungen an das Produkt.

Bei vielen Produkten sind beide Wege nur begrenzt möglich, wodurch letztlich die Größe des maximal zulässigen Kurzschlussstromes begrenzt wird. Im Fall der hier betrachteten Halbleiterleistungsmodule sind die maximalen Kurzschlussströme bei gebondeten Modulen deutlich kleiner als 50 kA, sofern die Geräteaußenwand sehr nahe an der Halbleitermodulwand liegt. Nur durch ausreichend großen Abstand von der Geräteaußenwand und ausreichender Entlüftung können größere Kurzschlussströme erreicht werden. Ein weiterer Lösungsansatz ist es, die Außenwand aus einem hochfesten Werkstoff zu gestalten, z.B. Stahlblech, welches die Gerätekosten und die Geräteabmessung erhöht.

Der Erfindung liegt die Aufgabe zugrunde, ein Halbleiterschaltmodul mit einem kostengünstigen und kompakten Gehäuseaufbau anzugeben, das den oben genannten Kurzschlussanforderungen standhält.

Der Erfindung liegt weiter die Aufgabe zugrunde, ein derartiges Gehäuse für ein Halbleiterschaltmodul anzugeben.

Diese Aufgabe wird durch ein Halbleiterschaltmodul gemäss dem Anspruch 1 gelöst.

Die Aufgabe wird ferner durch ein Gehäuse mit den in Anspruch 6 angegebenen Merkmalen gelöst.

Das erfindungsgemäße Halbleiterschaltmodul zeichnet sich dadurch aus, dass trotz kompakter und kostengünstiger Bauweise ein hoher Kurzschlusswert erreicht wird, wobei die Nachteile der herkömmlichen offenen Gehäuseaufbauten vermieden werden. Im Prinzip wird dies dadurch erreicht, dass im Kurzschlussfall der Druck über definierte Öffnungen abgeführt werden kann. Diese Öffnungen sind im normalen Betriebsfall durch dünne Wände verschlossen. Durch diesen Verschluss kann z.B. der bei gebondeten Halbleiterschaltmodulen erforderliche Verguss im Gehäuse gehalten werden und ein optisch geschlossenes Gehäuse realisiert werden. Die dünnen Wände werden im Kurzschlussfall aufgedrückt, wodurch Öffnungen im Gehäuse freigegeben werden, durch die der Druck entweichen kann. Die Öffnungen sind von der Größe her so gestaltet, dass auch im offenen Zustand ein Berühren von stromführenden Teilen nicht möglich ist, wodurch eine Personengefährdung ausgeschlossen wird. Des Weiteren gibt es keine Erhöhung der erforderlichen Spannungsabstände zu Nachbargeräten durch große Ausblasöffnungen und auch das Gerätedesign wird nicht beeinträchtigt.

In einer vorteilhaften Ausführungsform ist zumindest eine Außenwand des Halbleiterschaltmoduls als ein Teil des Gehäuses ausgebildet. Dadurch, dass die Modulaußenwand in Teilen der Gerätewand entspricht, kann eine besonders kompakte und kostengünstige Bauweise erzielt werden.

In einer weiteren vorteilhaften Ausführungsform ist das Halbleiterschaltmodul als Leistungsmodul mit einem Direct-Copper-Bonding (DCB) ausgeführt. Bei diesen Leistungsmodulen sind Leistungshalbleiter auf der DCB aufgelötet, die mit Bonddrähten auf der DCB verschaltet werden. Hier ergibt sich eine Steigerung der Kurzschlussfestigkeit bei Zuordnungsart 1 bei kompakter Bauweise und ohne Beeinträchtigung der Standardfertigungsprozesse, insbesondere des Vergusses.

In einer weiteren vorteilhaften Ausführungsform ist das Gehäuse aus isolierendem Kunststoff ausgeführt. Hierdurch ist, insbesondere wenn die Modulaußenwand (teilweise) dem Gehäuse entspricht, eine besonders kostengünstige Bauweise möglich.

In einer weiteren vorteilhaften Ausführungsform sind die dünnen Wände als Aufkleber ausgeführt. Die Ausprägung der dünnen Wände als selbstklebende Kunststoffteile (Aufkleber) ermöglicht es, variable Informationen auf diesen aufzudrucken, über die z.B. eine Identifikation des jeweiligen Schaltmoduls möglich ist, und auf kostengünstigem Wege auf dem Halbleiterschaltmodul aufzubringen.

Im Folgenden wird die Erfindung anhand der in den Figuren dargestellten Ausführungsbeispiele näher beschrieben und erläutert. Es zeigen:
- FIG 1: ein erfindungsgemäßes Leistungsmodul mit seitlich aufgeklebten Seitenwänden,
- FIG 2: das Leistungsmodul aus Fig 1 mit offenen Ausblasöffnungen.

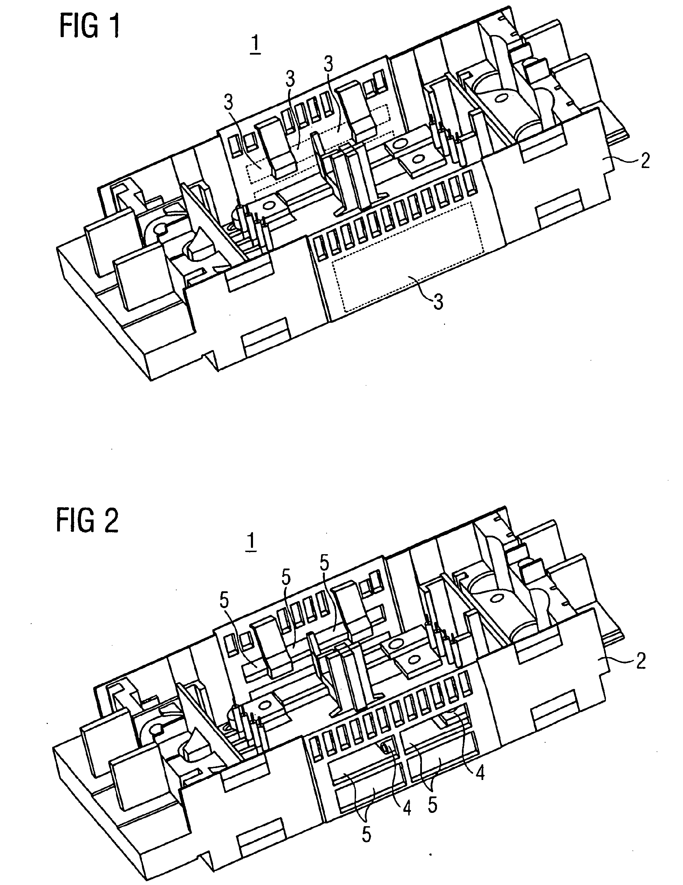

Fig 1 zeigt ein erfindungsgemäßes Halbleiterschaltmodul, das als Leistungsmodul 1 mit einem Direct-Copper-Bonding (DCB) ausgeführt ist. Die bei den Kurzschlüssen auftretenden Beanspruchungen sind kurzzeitige, schlagartige Druckwellen, die durch das Verdampfen von stromführenden Teilen 4, vor allem Bonddrähten, entstehen. Das erfindungsgemäße Leistungsmodul 1 - bestehend aus DCB mit aufgelöteten Leistungshalbleitern, die mit Bonddrähten auf der DCB verschaltet werden - zeichnet sich dadurch aus ,dass trotz kompakter und kostengünstiger Bauweise (Modulaußenwand - vorzugsweise aus isolierendem Kunststoff - ist gleich Geräteaußenwand) ein hoher Kurzschlusswert erreicht wird. Dies wird dadurch erreicht, dass im Kurzschlussfall der Druck über definierte Öffnungen 5 im Gehäuse 2 abgeführt werden kann. Diese Öffnungen 5 sind im normalen Betriebsfall durch dünne Wände 3, im Ausführungsbeispiel Aufkleber, verschlossen. Durch diesen Verschluss kann der bei gebondeten Halbleiterschaltmodulen erforderliche Verguss im Gehäuse 2 gehalten werden und ein optisch geschlossenes Gehäuse 2 realisiert werden. Diese dünnen Wände 3 (z.B. Aufkleber) werden im Kurzschlussfall aufgedrückt, wodurch Öffnungen 5 im Gehäuse 2 freigegeben werden, durch die der Druck entweichen kann. Die Ausprägung der dünnen Wände 3 als selbstklebende Kunststoffteile (Aufkleber) ermöglicht es darüber hinaus, variable Informationen auf diesen auszudrucken, über die zum Beispiel eine Identifikation des jeweiligen Schaltmoduls 1 möglich ist.

Fig 2 zeigt das Leistungsmodul 1 aus Fig 1 mit offenen Ausblasöffnungen 5 im Gehäuse 2. Die Öffnungen 5 sind von der Größe her so gestaltet, dass auch im offenen Zustand ein Berühren von stromführenden Teilen 4 nicht möglich ist, wodurch eine Personengefährdung ausgeschlossen wird.

Zusammenfassend betrifft die Erfindung ein Halbleiterschaltmodul mit einem Gehäuse, wobei das Gehäuse zur Abfuhr eines in einem Kurzschlussfall entstehenden Druckes Öffnungen aufweist. Der Erfindung liegt die Aufgabe zugrunde, ein Halbleiterschaltmodul mit einem kostengünstigen und kompakten Gehäuseaufbau anzugeben, bei dem nach einem Kurzschlussfall Anlagenteile oder Personen nicht gefährdet werden. Diese Aufgabe wird durch ein Halbleiterschaltmodul mit einem Gehäuse, wobei das Gehäuse zur Abfuhr eines in einem Kurzschlussfall entstehenden Druckes Öffnungen aufweist, die durch dünne Wände verschließbar sind, wobei die dünnen Wände derart dimensioniert sind, dass sie durch den im Kurzschlussfall entstehenden Druck zerstörbar oder entfernbar sind, und wobei die Öffnungen derart dimensioniert sind, dass stromführende Teile von außen nicht berührbar sind, gelöst. Das erfindungsgemäße Halbleiterschaltmodul zeichnet sich dadurch aus, dass trotz kompakter und kostengünstiger Bauweise ein hoher Kurzschlusswert erreicht wird, wobei die Nachteile der herkömmlichen offenen Gehäuseaufbauten vermieden werden. Im Prinzip wird dies dadurch erreicht, dass im Kurzschlussfall der Druck über definierte Öffnungen abgeführt werden kann. Diese Öffnungen sind im normalen Betriebsfall durch dünne Wände verschlossen. Durch diesen Verschluss kann z.B. der bei gebondeten Halbleiterschaltmodulen erforderliche Verguss im Gehäuse gehalten werden und ein optisch geschlossenes Gehäuse realisiert werden.

## Patentansprüche

1. Halbleiterschaltmodul (1) mit einem Gehäuse (2), wobei das Gehäuse (2) zur Abfuhr eines in einem Kurzschlussfall entstehenden Druckes Öffnungen (5) aufweist, die im normalen Betrieb des Halbleitermoduls durch dünne Wände (3) verschlossen sind, wobei die dünnen Wände (3) derart dimensioniert sind, dass sie durch den im Kurzschlussfall im Gehäuse entstehenden Druck zerstörbar oder entfernbar sind, und wobei die Öffnungen (5) derart dimensioniert sind, dass stromführende Teile (4) von außen nicht berührbar sind.

2. Halbleiterschaltmodul nach Anspruch 1,
wobei zumindest eine Außenwand des Halbleiterschaltmoduls (1) als ein Teil des Gehäuses (2) ausgebildet ist.

3. Halbleiterschaltmodul nach Anspruch 1 oder 2,
wobei das Halbleiterschaltmodul (1) als Leistungsmodul mit einem Direct-Copper-Bonding ausgeführt ist.

4. Halbleiterschaltmodul nach einem der vorhergehenden Ansprüche,
wobei das Gehäuse (2) aus isolierendem Kunststoff ausgeführt ist.

5. Halbleiterschaltmodul nach einem der vorhergehenden Ansprüche,
wobei die dünnen Wände (3) als Aufkleber ausgeführt sind.

6. Gehäuse (2) für ein Halbleiterschaltmodul (1) gemäss dem Anspruch 1.

7. Gehäuse nach Anspruch 6,
wobei ein Teil des Gehäuses (2) als zumindest eine Außenwand des Halbleiterschaltmoduls (1) ausgebildet ist.

8. Gehäuse nach Anspruch 6 oder 7,
wobei das Gehäuse (2) aus isolierendem Kunststoff ausgeführt ist.

9. Gehäuse nach einem der Ansprüche 6 bis 8,
wobei die dünnen Wände (3) als Aufkleber ausgeführt sind.

## Claims

1. Semiconductor switching module (1) with a housing (2), the housing (2) having openings (5), which are sealed by thin walls (3) during normal operation of the semiconductor module, to carry away pressure which occurs in the case of a short circuit, the thin walls (3) being dimensioned so that they can be destroyed or removed by the pressure which occurs in the housing in the case of a short circuit, and the openings (5) being dimensioned so that parts (4) which carry current cannot be touched from outside.

2. Semiconductor switching module according to Claim 1,
wherein at least one outer wall of the semiconductor switching module (1) is in the form of part of the housing (2).

3. Semiconductor switching module according to Claim 1 or 2,
wherein the semiconductor switching module (1) is implemented as a power module with a direct copper bonding.

4. Semiconductor switching module according to one of the preceding claims,
wherein the housing (2) is made of insulating plastic.

5. Semiconductor switching module according to one of the preceding claims,
wherein the thin walls (3) are implemented as adhesive labels.

6. Housing (2) for a semiconductor switching module (1) according to Claim 1.

7. Housing according to Claim 6,
wherein part of the housing (2) is in the form of at least one outer wall of the semiconductor switching module (1).

8. Housing according to Claim 6 or 7,
wherein the housing (2) is made of insulating plastic.

9. Housing according to one of Claims 6 to 8,
wherein the thin walls (3) are implemented as adhesive labels.

## Revendications

1. Module ( 1 ) de commutation à semi-conducteur comprenant un boîtier ( 2 ), le boîtier ( 2 ) ayant des ouvertures ( 5 ) d'évacuation de la pression se produisant dans un cas de court-circuit, ouvertures qui sont fermées par des parois ( 3 ) minces lorsque le module à semi-conducteur est en fonctionnement normal, les parois ( 3 ) minces ayant des dimensions telles qu'elles peuvent être détruites ou éliminées par la pression se créant dans le boîtier dans le cas d'un court-circuit et les ouvertures ( 5 ) ayant des dimensions telles que des parties ( 4 ) conduisant le courant ne peuvent pas être touchées de l'extérieur.

2. Module de commutation à semi-conducteur suivant la revendication 1,
dans lequel au moins une paroi extérieure du module ( 1 de commutation à semi-conducteur est constituée en partie du boîtier ( 2 ).

3. Module de commutation à semi-conducteur suivant les revendications 1 ou 2,
dans lequel le module ( 1 ) de commutation à semi-conducteur est réalisé en module de puissance ayant un Direct-Copper-Bonding.

4. Module de commutation à semi-conducteur suivant l'une des revendications précédentes,
dans lequel le boîtier ( 2 ) est réalisé en matière plastique isolante.

5. Module de commutation à semi-conducteur suivant l'une des revendications précédentes,
dans lequel les parois ( 3 ) minces sont réalisées en étiquettes adhésives.

6. Boîtier ( 2 ) pour un module ( 1 ) de commutation à semi-conducteur suivant la revendication 1.

7. Boîtier suivant la revendication 6,
dans lequel une partie du boîtier ( 2 ) est formée en tant qu'au moins une paroi extérieure du module ( 1 ) de commutation à semi-conducteur.

8. Boîtier suivant la revendication 6 ou 7,
dans lequel le boîtier ( 2 ) est réalisé en une matière plastique isolante.

9. Boîtier suivant l'une des revendications 6 à 8,
dans lequel les parois ( 3 ) minces sont réalisées sous la forme d'étiquettes adhésives.
